Europäisches Patentamt

European Patent Office

Office européen des brevets

(11) Publication number : **0 507 570 A2**

## (12) EUROPEAN PATENT APPLICATION

(21) Application number : 92302870.8

(22) Date of filing : 01.04.92

(51) Int. Cl.$^5$ : **G01R 31/36**

(30) Priority : **04.04.91 GB 9107077**

(43) Date of publication of application :
**07.10.92 Bulletin 92/41**

(84) Designated Contracting States :
**AT BE CH DE DK ES FR GB GR IT LI LU MC NL PT SE**

(71) Applicant : **Yang, Tai-Her**
**5-1 Taipin Street**
**Si-Hu Town Dzan-Hwa (TW)**

(72) Inventor : **Yang, Tai-Her**
**5-1 Taipin Street**
**Si-Hu Town Dzan-Hwa (TW)**

(74) Representative : **Arthur, Bryan Edward et al**
**Withers & Rogers 4 Dyer's Buildings Holborn**
**London EC1N 2JT (GB)**

(54) **Method of estimating residual battery life.**

(57) The invention provides a method of estimating the residual life of a battery by measuring its internal resistance and the current being taken from the battery by the load and computing from these and from the predetermined characteristic of the battery the charge remaining in the battery. This charge may be divided by the average current taken by the load to obtain a measure of the remaining life time. The invention is applicable to both rechargeable and disposable batteries.

FIG. 1

EP 0 507 570 A2

The invention relates to a method of estimating the residual life of a battery incorporated in battery operated apparatus.

Batteries are widely used where a portable or independent power supply is required in electrical systems, for example in portable telephones, business machines, communication systems, uninterruptable power supplies and for emergency lighting or other emergency facilities. However, it is difficult and uncertain to estimate the residual power or life time of a partly discharged battery and thus such batteries may be inefficiently used or may not be recharged or in the case of disposable batteries replaced in good time. It is an object of the present invention to provide a method of estimating the residual life of a battery so that batteries may be used more efficiently and/or more reliably.

The invention which is defined in the appended claims depends on the fact that the residual charge in a battery at any time is a function of the battery's internal resistance. This function may be determined for any particular type of battery so that by measuring the internal resistance of the battery and estimating the charge that has been used since the last measurement, the residual life may be estimated to a sufficient accuracy.

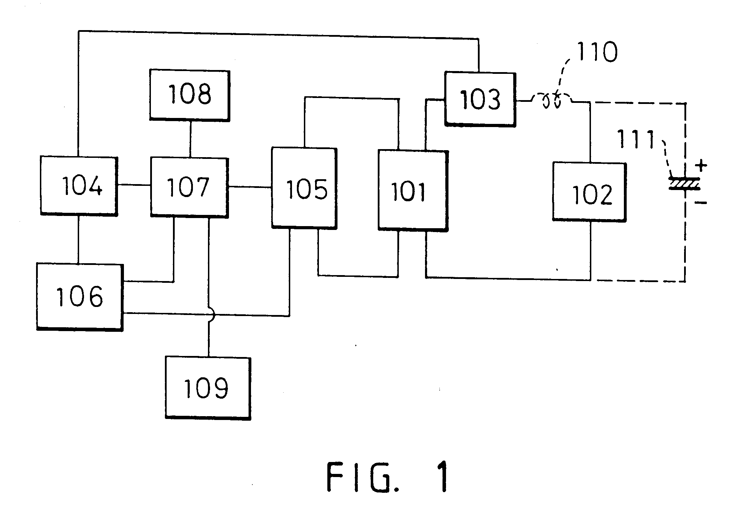

The invention will be further described with reference to the accompanying drawing which is a block diagram illustrating the operation of an apparatus for carrying out the method of the invention.

Referring now to the drawing, a battery 101, supplies current to a load 102 through a current measuring device 103, the current measurement is applied to an integrator 104 which averages and integrates the current measurements.

Connected across the battery 101 is a detection circuit 105 arranged to operate intermittently so as at intervals to measure the internal resistance of the battery 101. A timer 106 initiates operation of the device 105 at intervals and each time also resets the integrator 104.

A processor 107 stores the predetermined characteristic of the battery and on receiving the resistance measurement from the detector 105 determines from this characteristic the residual charge corresponding to the measured resistance value. From this residual charge there is continually subtracted the integrated value of the current used since the resistance measurement derived from the integrator 104, the difference being a measure of the estimated charge remaining in the battery. This charge may be compared with a preset threshold and caused to trigger an alarm 108 when it falls below the threshold value. Further the charge or the estimated remaining time obtained by dividing the charge by an average value obtained from the integrating unit 104 may be displayed on a display 109.

To avoid excessive voltage fluctuations at those instances at which the detector 105 measures the battery resistance, it may be desirable to include an inductance 110 in series with the load and a capacitor 111 in parallel with the load.

The measuring comparison and computing circuits may be entirely digital in operation or analogue components may be employed where appropriate. Also the circuit could be constructed entirely from solid state components or where appropriate electromechanical devices such as relays and mechanical timers could be used.

In a modification the timer 106 may be replaced by a manually operated switch so that a battery life determination is made only when the user so requires thus minimising disturbances in the supply to the load.

## Claims

1. Method of estimating the residual life of a battery comprising measuring at intervals the battery's internal resistance, integrating the current supplied by the battery to the load since the last resistance measurement, obtaining from the predetermined battery characteristic the residual charge corresponding to the last measured resistance and subtracting the integrated current to obtain an estimate of the residual charge.

2. A method according to claim 1, further including the step of dividing the residual charge so estimated by the average load current to obtain the estimated remaining life time of the battery.

3. A method according to claim 2, in which the estimated life of the battery is displayed.

4. A method according to any preceding claim, in which the residual charge or expected life is compared with a preset threshold and caused to give an alarm signal when it falls below the threshold.

5. A method according to any preceding claim, in which at least the integrating and computing steps are carried out by digital circuits.

6. A method according to any preceding claim, in which the battery is a rechargeable battery.

7. A method according to any preceding claim, in which the resistance measurement is initiated and the integrator reset by means of a manual switch.

FIG. 1